# EUROPÄISCHE PATENTSCHRIFT

(11) **EP 3 817 881 B1**
(45) Veröffentlichungstag und Bekanntmachung des Hinweises auf die Patenterteilung: **17.01.2024**
(21) Anmeldenummer: 19731661.5
(22) Anmeldetag: 13.06.2019
(51) Int. Cl.: B23K 1/00, B23K 35/02, B23K 35/26, B23K 35/30, B23K 101/38, B23K 101/36

(54) **VERFAHREN ZUR HERSTELLUNG EINER HOCHTEMPERATURFESTEN BLEIFREIEN LOTVERBINDUNG UND ANORDNUNG MIT EINER HOCHTEMPERATURFESTEN BLEIFREIEN LOTVERBINDUNG**
METHOD FOR MANUFACTURING A HIGH TEMPERATURE RESISTANT LEAD-FREE SOLDER CONNECTION AND ARRANGEMENT WITH A HIGH TEMPERATURE RESISTANT LEAD-FREE SOLDER CONNECTION
PROCÉDÉ DE FABRICATION D'UNE CONNEXION DE SOUDURE SANS PLOMB RÉSISTANT AUX TEMPÉRATURES ÉLEVÉES ET ARRANGEMENT AVEC UN JOINT SOUDURE SANS PLOMB RÉSISTANT AUX HAUTES TEMPÉRATURES

(30) Priorität: 06.07.2018 DE 102018116410
(43) Veröffentlichungstag der Anmeldung: 12.05.2021
(73) Patentinhaber: Endress+Hauser SE+Co. KG, 79689 Maulburg (DE)
(72) Erfinder: SCHMIDT, Elke, 79713 Bad Säckingen (DE); BIRGEL, Dietmar, 79650 Schopfheim (DE)
(74) Vertreter: Hahn, Christian
(86) Internationale Anmeldenummer: PCT/EP2019/065433
(87) Internationale Veröffentlichungsnummer: WO 2020/007583

(56) Entgegenhaltungen:
- DE-A1-102005 043 279
- US-A1- 2007 089 811
- US-A1- 2011 220 704
- US-A1- 2017 173 718
- US-B1- 6 342 442

## Beschreibung

Die Erfindung betrifft ein Verfahren zur Herstellung einer hochtemperaturfesten bleifreien Lotverbindung zwischen einer Leiterplatte und einem Bauelement (siehe z.B. US 2011/220704 A1) Ferner betrifft die Erfindung eine Anordnung mit einer hochtemperaturfesten bleifreien Lotverbindung sowie ein Feldgerät der Automatisierungstechnik mit einer hochtemperaturfesten bleifreien Lotverbindung.

Beim Löten handelt es sich um ein thermisches Verfahren, mit dem eine stoffschlüssige Fügeverbindung erhalten wird, entweder durch Schmelzen eines Lotes (Schmelzlöten) oder durch Diffusion an den Grenzflächen (Diffusionslöten). Leiterplatten mit darauf gelöteten Bauelementen werden in den von der Endress+Hauser Gruppe hergestellten und vertriebenen Feldgeräten der Automatisierungstechnik in den unterschiedlichsten Ausgestaltungen eingesetzt. Als Feldgeräte werden im Rahmen dieser Anmeldung im Prinzip alle Messgeräte zur Bestimmung und/oder Überwachung von Prozessgrößen bezeichnet, die prozessnah eingesetzt werden und prozessrelevante Informationen liefern oder verarbeiten. Dabei handelt es sich beispielsweise um Füllstandsmessgeräte, Durchflussmessgeräte, Druck- und Temperaturmessgeräte, pH-Redoxpotentialmessgeräte, Leitfähigkeitsmessgeräte, usw., welche die entsprechenden Prozessgrößen Füllstand, Durchfluss, Druck, Temperatur, pH-Wert bzw. Leitfähigkeit erfassen. Bei Feldgeräten liegen durch den prozessnahen Einsatz an gewisse Komponenten bzw. deren Lotverbindungen besonders hohe Anforderungen vor, da diese zum Beispiel im Wesentlichen unmittelbar den Umgebungstemperaturen ausgesetzt sind.

Aus dem Stand der Technik sind unterschiedliche Lötverfahren bekannt, deren Auswahl durch die Anwendung (insb. der zu verlötenden Bauelemente, des Lots und/oder dem bei einem bestimmungsgemäßen Einsatz vorliegenden Temperaturbereich) bestimmt wird. Eine Klassifizierung erfolgt hierbei werden nach der Liquidustemperatur des Lotes: Bei einer Liquidustemperatur von unter 450°C handelt es sich definitionsgemäß um eine sogenannte Weichlotverbindung; ab 450 °C spricht man von einer Hartlotverbindung, da letztere im Allgemeinen eine höhere mechanische Festigkeit aufweisen.

Ein in industriellen Fertigungslinien zur Herstellung von Leiterplatten weit verbreitetes Lötverfahren ist das Reflow-Löten, bei dem oberflächen-montierbare Bauelemente, so genannte 'Surface Mounted Devices' (kurz: SMD-Bauelemente) mit ihren Kontakten direkt an vorgesehene Anschlüsse aufgelötet werden. Hierzu werden die SMD-Bauelemente mit Bestückungsautomaten maschinell auf die mit Lotpaste versehene Kontakte auf der Leiterplatte platziert und gemeinsam mit einem Reflow-Lötprozess in einem Reflow-Lötofen aufgelötet. Damit wird gleichzeitig eine Vielzahl von Lotverbindungen, in der Regel Weichlotverbindungen, erzeugt.

Neben den SMD Bauelementen gibt es spezielle Bauelemente, die bedingt durch ihre Funktion größere Abmessungen aufweisen. Diese Bauelemente sind bevorzugt als Through Hole Technology-Bauelemente - kurz THT-Bauelemente ausgebildet. THT Bauteile werden typischerweise in einem Wellenlöten verlötet. Dabei wird die Leiterplatte über eine sogenannte Lotwelle gefahren, die dadurch erzeugt wird, dass flüssiges Lot durch einen schmalen Spalt gepumpt wird.

Um THT-Bauelemente in einen durch eine große Anzahl von SMD-Bauelementen dominierten Herstellungsprozess einzubinden, wird vorzugsweise das als Backside-Reflow Löten bekannt gewordene und z.B. in der Patentschrift DE 102 11 647 B4 beschriebene Verfahren verwendet. Beim Backside-Reflow Löten werden auf der ersten Oberfläche angeordnete THT-Bauelemente über Kopf von der zweiten Oberfläche der Leiterplatte her zusammen mit auf der zweiten Oberfläche angeordneten SMD-Bauelementen in einem gemeinsamen Reflow-Prozess verlötet. Dadurch wird die kostengünstige Herstellung beidseitig mischbestückter Leiterplatten ermöglicht.

Für den Fall, dass nicht alle Bauelemente in einen gemeinsamen Reflow-Lötprozess einbindbar sind, kommen Selektiv-Lötverfahren zum Einsatz, in denen eine Lötstelle gezielt einzeln bearbeitet werden kann. Dadurch wird die thermische Belastung der gesamten Baugruppe reduziert und ggf. ein Aufschmelzen bereits bestehender Lotverbindungen verhindert. In der DE 10 2006 035 528 A1 ist beispielsweise das Selektiv-Wellenlöten von temperaturempfindlichen THT-Bauelemente offenbart. Das Selektiv-Wellenlöten ist ein Spezialfall des vorstehend genannten Wellenlötens. Weitere aus dem Stand der Technik bekannte Selektiv-Lötverfahren umfassen das Löten mit einem Lötkolben, Lichtlötverfahren, etwa mit einem Laser oder Infrarot-Strahlung, das Induktionslöten oder Löten mittels Mikrowellen, sowie das Bügel-Selektivlötverfahren, bei dem ein Bügel auf die Lötstelle gepresst wird und die vorgegebene Löttemperatur mittels eines den Bügel durchfließenden elektrischen Stroms erreicht wird. Automatisierte Lötautomaten, die zum Bügel-Selektivlöten ausgebildet sind, werden beispielsweise von der Firma "Eutect" hergestellt und vertrieben.

Ferner ist aus dem im Stand der Technik der Einsatz von Lotformteilen bei Selektiv-Lötverfahren bekannt. In der DE 10 2012 200 021 A1 ist beispielsweise die Verwendung eines Lotformteils vorgeschlagen, mit dem die Anschlusspins eines THT-Bauelement in einem Selektiv-Wellenlöten gelötet werden. In der DE 10 2006 021 335 A1 ist die Verwendung eines Lotformteils für eine zu Testzwecken erforderlichen Überbrückung von Anschlussflächen offenbart. Das Lotformteil weist dabei eine höhere Schmelztemperatur als die Löttemperatur der Reflow-gelöteten Bauelemente auf, und kann daher in einem Selektiv-Lötverfahren verlötetet werden.

Die Löttemperatur wird zum einen durch das Lot bestimmt; beispielsweise werden in zunehmenden Maße aufgrund von Schwermetall-begrenzenden Verordnungen bleifreie Lote mit höheren Schmelzpunkten verwendet. Zum anderen muss sichergestellt sein, dass bestimmte Bauelemente bzw. deren Lotverbindungen auch den bei einem bestimmungsgemäßen Einsatz des Feldgeräts maximal vorliegenden Temperaturen standhalten. Bei diesen Bauelementen handelt es sich um die vorstehend erwähnten prozessnah angeordneten Komponenten, welche den Umgebungstemperaturen im Wesentlichen unmittelbar ausgesetzt sind. Für Feldgeräte, die in Hochtemperaturanwendungen zum Einsatz kommen, liegt daher an die prozessnah angeordneten Lotverbindungen die Anforderung vor, dass diese auch unter Kontakt mit sehr hohen Umgebungstemperaturen (beispielsweise von über 150°C) vor einem Wiederaufschmelzen geschützt sind. Zudem ist eine ausreichende mechanische Festigkeit der Lötverbindungen gegenüber den in einer Prozessanlage auftretenden Vibrationen erforderlich.

Hochtemperaturfeste Lotverbindungen werden im Stand der Technik beispielsweise mittels einem Diffusionslöten erzeugt. Beim Diffusionslöten wird eine Oberflächenlegierung erzeugt, das Werkstück in der Tiefe aber nicht aufgeschmolzen. Das Diffusionslöten zeichnet sich durch die Bildung von intermetallischen Phasen, insbesondere über die ganze Dicke der Lotverbindung, aus, wodurch die Lotverbindung eine besonders hohe mechanische Festigkeit aufweist. Da das Diffusionslöten prinzipiell sehr lange Lötzeiten (beispielsweise in typischen Anwendungen bis zu 30 Minuten), erfordert, istdiese Löttechnik für industrielle Fertigungslinien nachteilig.

Kürzlich wurde ein neuartiges, bleifreies Lotformteil aus einem Verbundwerkstoff entwickelt, mit dem eine hochtemperaturfeste Lotverbindung erhalten werden kann. Das Lotformteil ist in dem wissenschaftlichen Artikel "Preform-based diffusion soldering for use under conventional soldering process parameters" von H. M. Daoud et al. (European Microelectronics and Packaging Conference (EMPC) & Exhibition, DOI 10.23919/EMPC.2017.8346889) unter dem Namen PFDS400^{®} vorgestellt und weist eine erste Verbundkomponente aus einer Zinn-haltigen Lotlegierung auf, die in einer die zweite Verbundkomponente bildenden Kupfermatrix angeordnet ist. Die Zinn-haltige Lotlegierung ist dabei in Schichten bzw. Lagen in der Kupfermatrix angeordnet. Das Lotformteil wird beim Löten vorzugsweise derart orientiert, dass die Schichten bzw. Lagen im Wesentlichen parallel zu den beiden lötfähigen Oberfläche der zu verbindenden Komponenten angeordnet sind. Das Lotformteil zeichnet sich dadurch aus, dass bei einem Löten, insbesondere einem Weichlötprozess, intermetallische Phasen gebildet werden, die entlang der Schichten der Zinn-haltigen Lotlegierung verlaufen. Durch den lagenförmigen Aufbau des Lotformteils sind die intermetallischen Phasen über die ganze Dicke der Lotverbindung im Wesentlichen gleichmäßig verteilt angeordnet. Dadurch wird eine Lotverbindung mit einer sehr hohen Wiederaufschmelz-Temperatur von bis zu 400°C und mit einer ausgezeichneten mechanischen Beständigkeit erhalten. In dem wissenschaftlichen Artikel ist vorgeschlagen, das Lotformteil mit einem konventionellen Weichtlöt-Massenlötprozess zu kombinieren, nämlich mit einem eingangs beschriebenen Reflow-Lötprozess mit Löttemperaturen von ca. 250°C und Lötzeiten von ca. 10 min. Da in einem Reflow-Lötprozess die ganze Leiterplatte im Lötofen der Löttemperatur ausgesetzt ist, stellt diese Kombination von Lötzeit und -temperatur in der Praxis einen zu hohen thermischen Stress für weitere auf der Leiterplatte angeordnete Bauelemente bzw. deren Lotverbindungen dar.

Der Erfindung liegt daher die Aufgabe zugrunde, eine Lösung anzugeben, um eine hochtemperaturfeste bleifreie Lotverbindung auf einer Leiterplatte unter möglichst geringer thermischer Belastung der gesamten Leiterplatte zu erhalten.

Die Aufgabe wird durch ein Verfahren zur Herstellung einer hochtemperaturfesten bleifreien Lotverbindung, eine hochtemperaturfeste bleifreie Lotverbindung sowie ein Feldgerät der Automatisierungstechnik mit einer hochtemperaturfesten bleifreien Lotverbindung gelöst.

Hinsichtlich des Verfahrens wird die Aufgabe gelöst durch ein Verfahren zur Herstellung einer hochtemperaturfesten bleifreien Lotverbindung zwischen einer Leiterplatte und einem Bauelement gemäß dem Anspruch 1.

Die erfindungsgemäße Kombination des Lotformteils mit dem Bügel-Selektivlötverfahren bzw. die Verwendung des Lotformteils in dem Bügel-Selektivlötverfahren weist folgende Vorteile auf:
1. In dem lokal begrenzten Bügel-Selektivlötverfahren sind weitere auf der Oberfläche der Leiterplatte angeordnete Bauelemente vor zu hoher thermischer Beanspruchung geschützt. Bei den weiteren Bauelementen handelt es sich insbesondere um SMD-Bauelemente, beispielsweise mit leichter schmelzbaren Plastikkomponenten, welche etwa in einem dem Bügel-Selektivlötverfahren vorausgehenden Reflow-Lötverfahren auf die Leiterplatte gelötet worden sind.
2. In dem Bügel-Selektivlötverfahren kann in vergleichsweise kurzer Zeit die zum Löten des Lotformteils und zur Ausbildung der intermetallischen Phasen erforderliche Temperatur erreicht werden. Eine kürzere Lötzeit ist aufgrund der damit verbundenen beschleunigten Fertigung prinzipiell wünschenswert. Darüber hinaus führen kürzere Lötzeiten bei gleicher Löttemperatur zu einer weiteren Reduzierung des thermischen Stresses, insbesondere für an die hochtemperaturfeste Lotverbindung angrenzende Baugruppen.
3. Durch das Aufpressen des Bügels mit einer Haltekraft herrscht ein Druck auf die Lötstelle. Dadurch wird das Ausbilden der intermetallischen Phasen in der hochtemperaturfesten Lotverbindung unterstützt bzw. beschleunigt und somit eine weitere vorteilhafte Verkürzung der Lötzeit erreicht.
4. In dem Bügel-Selektivlötverfahren wird ein verfahrbarer Bügel eingesetzt, mit dem sich eine hohe räumliche Präzision bei der Herstellung der hochtemperaturfesten Lotverbindung erreichen lässt.
5. Das Bügel-Selektivlötverfahren eignet sich für den Einsatz in industriellen Fertigungslinien und die Befestigung des Lotformteils selbst ist in einen weiteren Verfahrensschritt in der Fertigung der Leiterplatte einbindbar.

In einer vorteilhaften Ausgestaltung des erfindungsgemäßen Verfahrens wird in dem Bügel-Selektivlötverfahren eine Lötzeit verwendet, die kleiner als eine Minute, insbesondere kleiner als 30 Sekunden, ist. Die Erfindung eignet sich insbesondere für industrielle Fertigungslinien, bei denen kürzere Fertigungszeiten erhebliche Ersparnisse mit sich bringen. Zudem werden bei derart kurzen Lötzeiten ggf. die an die hochtemperaturfeste Lotverbindung angrenzende Baugruppe im Wesentlichen kaum beansprucht.

In einer weiteren Ausgestaltung des erfindungsgemäßen Verfahrens umfasst die Befestigung des Lotformteils auf der lötfähigen Oberfläche der Leiterplatte zumindest die folgenden Schritte:
- Aufbringen, insbesondere Aufdrucken, von Lotpaste auf eine vorgesehene Kontaktfläche auf der lötfähigen Oberfläche der Leiterplatte;
- Bestücken der die Lotpaste aufweisenden, vorgesehenen Kontaktfläche mit dem Lotformteil

In einer Weiterbildung dieser Ausgestaltung umfasst die Befestigung des Lotformteils auf der lötfähigen Oberfläche der Leiterplatte folgenden Schritt:
- Verlöten des Lotformteils mit der Kontaktfläche in einem Weichlötverfahren.

In einer weiteren Ausgestaltung des erfindungsgemäßen Verfahrens umfasst die Befestigung des Lotformteils auf der lötfähigen Oberfläche der Leiterplatte folgenden Schritt:
- Kleben des Lotformteils auf die lötfähige Oberfläche der Leiterplatte, insbesondere unter Verwendung eines Flussmittels.

In einer besonders vorteilhaften Ausgestaltung des erfindungsgemäßen Verfahrens ist die Befestigung des Lotformteils zumindest teilweise in einen gemeinsamen Druck- und/oder Bestückungs- und/oder Reflow-Prozess einbindbar, bei welchem weitere Bauelemente, insbesondere SMD-Bauelemente, auf die Leiterplatte aufgelötet werden.

Das Lotformteil selbst wird also beispielsweise Im Rahmen des Bestückungsprozesses mittels Lotpaste auf der lötfähigen Oberfläche der Leiterplatte befestigt und anschließend in einem gemeinsamen Reflow-Prozess aufgelötet. Für den Fall, dass das Lotformteil mittels Flussmittels auf die lötfähige Oberfläche der Leiterplatte geklebt ist, ist das Aufkleben in den bei einem Reflow-Lötprozess standardmäßigen Vorbereitungsschritt des Aufbringens von Flussmittel einbindbar.

In einer weiteren Ausgestaltung des erfindungsgemäßen Verfahrens umfasst das Bügel-Selektivlötverfahren folgenden Schritt:
- Verlöten einer der lötfähigen Oberfläche zugewandten zweiten Oberfläche des Lotformteils mit der lötfähigen Oberfläche.

In dieser Ausgestaltung wird auch das Lotformteil selbst (ggf. zusätzlich zum vorausgehenden Reflow-Löten oder Kleben) in dem Bügel-Selektivlötverfahren mit der lötfähigen Oberfläche verlötet. In einer Ausgestaltung des erfindungsgemäßen Verfahrens wird ein Lotformteil verwendet, das als metallische Matrix eine Kupfermatrix aufweist. Hierbei sei wieder auf die vorstehend genannte wissenschaftliche Veröffentlichung von H. Daoud *et al.* verwiesen

In einer besonders vorteilhaften Ausgestaltung des erfindungsgemäßen Verfahrens wird hintereinander eine Vielzahl von hochtemperaturfesten Lotverbindungen erzeugt, indem der Bügel in der Ebene der Leiterplatte und/oder die Leiterplatte verfahren wird und die Schritte des Bügel-Selektivlötverfahrens jeweils nacheinander mit jeweils einem Bauelement- Lotformteil Paar durchgeführt werden.

In einer weiteren besonders vorteilhaften Ausgestaltung des erfindungsgemäßen Verfahrens wird im Wesentlichen gleichzeitig mit einer Vielzahl von Bügeln eine Vielzahl von hochtemperaturfesten Lotverbindungen erzeugt, indem die Vielzahl der Bügel im Wesentlichen gleichzeitig die Schritte des Bügel-Selektivlötverfahrens mit jeweils einem Bügel für ein Bauelement- Lotformteil Paar durchführen.

Hinsichtlich der Anordnung mit einer hochtemperaturfesten bleifreien Lotverbindung wird die Aufgabe durch eine Anordnung mit einer hochtemperaturfesten bleifreien Lotverbindung gemäß dem Anspruch 11 gelöst. Die Eigenschaften der erfindungsgemäßen bleifreien Lotverbindung sind zum einen an den intermetallischen Schichten bzw. Lagen erkennbar, bsp. mitttels eines Schnittbilds. Zum anderen ist die Verwendung eines Bügel-Selektivlötverfahrens beim Löten eines Bauelements anhand des Abdrucks des Bügels auf dem Bauelement deutlich erkennbar.

In einer Ausgestaltung der Lotverbindung beträgt der Anteil der intermetallischen Phasen an der Lotverbindung zumindest 5%, insbesondere zumindest 10%.

Hinsichtlich des Feldgeräts der Automatisierungstechnik wird die Aufgabe durch ein Feldgerät der Automatisierungstechnik gemäß dem Anspruch 13 gelöst.

Hierbei sei wieder auf die eingangs erwähnten Feldgeräte der Automatisierungstechnik verwiesen, die eine für den Hochtemperatureinsatz ausgestaltete und prozessnah angeordnete sensitive Komponente aufweisen.

Für den Hochtemperatureinsatz vorgesehene Feldgeräte umfassen beispielsweise keramische Drucksensoren oder vibronische Grenzstandsschalter, bei denen die schwingfähige Einheit mittels einer Spule induktiv angetrieben wird. Selbstverständlich ist die Erfindung nicht auf diese Beispiele für die Feldgeräte beschränkt.

Die Erfindung wird anhand der nachfolgenden, nicht maßstabsgetreuen Figuren näher erläutert, wobei gleiche Bezugszeichen gleiche Merkmale bezeichnen. Wenn es die Übersichtlichkeit erfordert oder es anderweitig sinnvoll erscheint, wird auf bereits erwähnte Bezugszeichen in nachfolgenden Figuren verzichtet. Es zeigt:
Fig. 1a, 1b, 1c: Eine erste Ausgestaltung des erfindungsgemäßen Verfahrens und eine Ausgestaltung der Anordnung mit der hochtemperaturfesten Lotverbindung;
Fig. 2a, 2b: Eine zweite Ausgestaltung des erfindungsgemäßen Verfahrens;
Fig. 3: Eine Ausgestaltung eines Feldgeräts der Automatisierungstechnik mit der hochtemperaturfesten Lotverbindung.

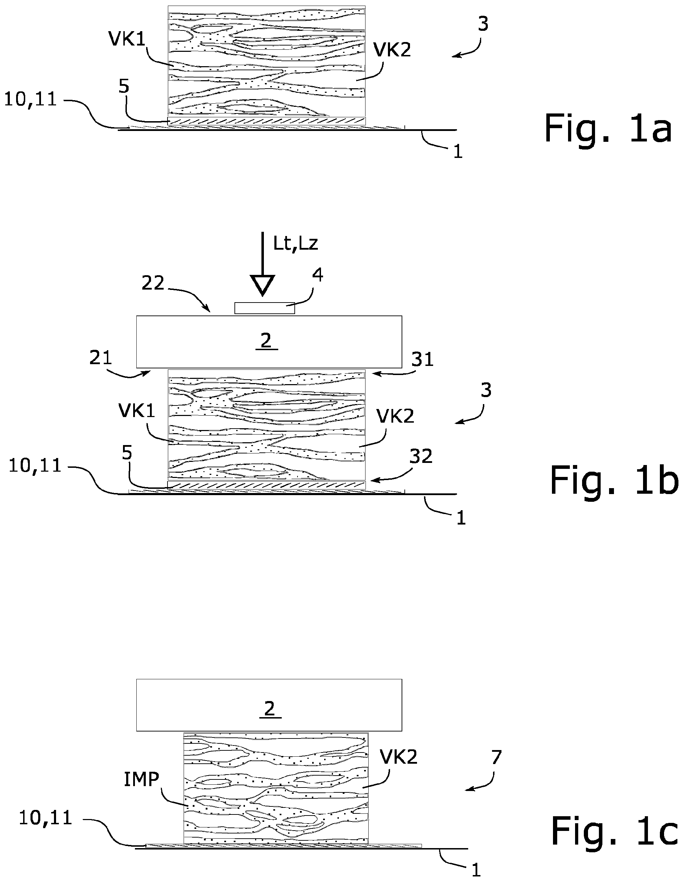

In Fig. 1a bis 1c sind in einer Schnittansicht die Schritte des erfindungsgemäßen Verfahrens in einer Ausgestaltung für einen Ausschnitt einer Leiterplatte 1 dargestellt, sowie eine durch das Verfahren erhaltene Lotverbindung 7. Zur besseren Veranschaulichung ist das Lotformteil 3 hier als wesentlich vergrößert dargestellt.

In Fig.1a ist ein Lotformteil 3 gezeigt, das aus dem Verbundwerkstoff PFDS400^{®} besteht, bei dem eine Sn-haltige Lotlegierung als erste Verbundkomponente VK1 im Wesentlichen schichtförmig in einer die zweite Verbundkomponente VK2 bildenden Kupfermatrix eingebettet ist. Das Lotformteil 3 ist dabei derart auf eine hier als Kontaktfläche 10 ausgebildete lotfähige Oberfläche 11 der Leiterplatte 1 aufgebracht, dass die Schichten bzw. Lagen der ersten Verbundkomponente VK1 im Wesentlichen parallel zu der lotfähigen Oberfläche 11 angeordnet sind. Die Schichten mit der Sn-haltigen Lotlegierung sind hier als gepunktet dargestellt.

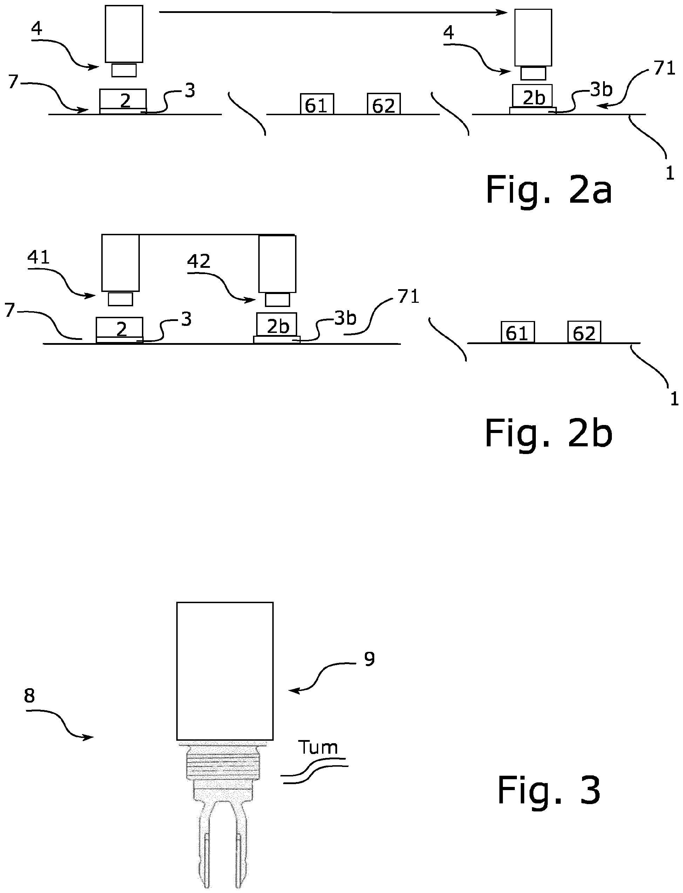

In dieser Ausgestaltung ist das Lotformteil 3 mithilfe von Lotpaste 5 auf die lotfähige Oberfläche 11 aufgebracht. Die Lotpaste 5 und das Lotformteil 3 wurden dabei vorteilhaft in einem dem erfindungsgemäßen Verfahren vorausgehenden Verfahren aufgebracht, bsp. im Rahmen eines gemeinsamen Bedruck- und Bestückungsprozesses beim Aufbringen von weiteren, als SMD-Bauelementen ausgebildeten weiteren Bauelementen 61,62 (in Fig. 2 gezeigt). Hierbei wurde das Lotformteil 3 selbst mit einer der lotfähigen Oberfläche 11 zugewandten zweiten Oberfläche 32 aufgelötet, insbesondere in einem gemeinsamen Reflow-Prozess mit den weiteren Bauelementen 61,62. Alternativ ist es möglich, dass Lotformteil 3 nicht mittels eines Reflow-Lötens zu verlöten, sondern nur mittels Flussmittel zu kleben. Auch dieser Schritt ist in den Reflow-Prozess einbindbar, da ein Vorbereitungsschritt beim Reflow-Löten das Aufbringen von Flussmittel umfasst.

Auf das Lotformteil 3 wird nun ein Bauelement 2 aufgebracht. Das Bauelement 2 weist eine dem Lotformteil 3 zugewandte erste Oberfläche 21 aus, bsp. aus Messing. Bei dem Bauelement 2 handelt es sich um ein spezielles, prozessnah angeordnetes Bauelement 2 eines Feldgeräts 8 der Automatisierungstechnik (das Feldgerät 8 ist in Fig. 3 gezeigt), das bei einem bestimmungsgemäßen Einsatz gemäß der Spezifikation des Feldgeräts 8 besonders hohen Umgebungs- bzw. Prozesstemperaturen Tum aussetzbar ist, insbesondere Temperaturen oberhalb 150°C, beispielsweise zwischen 180°C bis 200°C. Daher muss sichergestellt sein, dass auch die Lotverbindung 7 des Bauelements 2 diesen Temperaturen standhält, also als eine hochtemperaturfeste Lotverbindung 7 ausgebildet ist. Gleichzeitig sollte bei deren Herstellung die restliche Baugruppe, insb. die weiteren Bauelementen 61,62, einem möglichst geringen thermischen Stress ausgesetzt sein.

Dies wird mittels der Kombination des Lotformteils 3 mit dem Bügel-Selektivlötverfahren erreicht, bei dem nun wie in Fig. 1b gezeigt auf die dem Lotformteil 3 abgewandte zweite Oberfläche 22 des Bauelements 2 mit einer Haltekraft ein Bügel 4 gepresst wird.

Der Bügel 4 wird anschließend von einem Strom durchflossen, um dadurch die Löttemperatur Lt zu erreichen, bei der sich aus der in Schichten angeordneten Sn-haltigen Lotlegierung die intermetallischen Phasen IMP bilden. Die beim Köten gebildeten intermetallischen Phasen IMP sind dadurch in Schichten bzw. Lagen (als gepunktet dargestellt) angeordnet, die im Wesentlichen parallel zur lötfähigen Oberfläche verlaufen. Anschließend wird der Bügel 4 von dem Bauelement 2 wegbewegt.

Die in dem Bügel-Selektivlötverfahren gebildeten intermetallischen Phasen IMP weisen eine Wiederaufschmelztemperatur von ca. 400°C auf, wodurch die Hochtemperaturfestigkeit der Lotverbindung 7 erhalten wird. Die in Schichten angeordneten intermetallischen Phasen IMP sind wie in Fig. 1c gezeigt nicht nur auf die Grenzfläche zwischen der lotfähigen Oberfläche 11 und der zweiten Oberfläche 32 des Lotformteils 3 und auf die Grenzfläche zwischen der ersten Oberfläche 31 des Lotformteils 3 und der ersten Oberfläche 21 des Bauelements beschränkt, sondern sind über die gesamte Dicke der Lotverbindung 7 im Wesentlichen gleichmäßig verteilt angeordnet (d.h. in einer zu der lötfähigen Oberfläche 11 senkrechten Richtung). Die schichtförmigen intermetallischen Phasen IMP machen dabei einen deutlich erkennbaren Anteil an der gesamten Lotverbindung 7 aus. Hierdurch weist die Lotverbindung 7 ausgezeichnete mechanische Eigenschaften, bsp. eine hohe mechanische Beständigkeit gegenüber Scherkräften, auf.

Für den Fall, dass das Lotformteil 3 in einem dem Bügel-Selektivlöten vorausgehenden Lötverfahren mit Lotpaste 5 auf der lötfähige Oberfläche 11 befestigt, insbesondere aufgelötet wurde, bildet sich in der Grenzfläche zwischen der lotfähigen Oberfläche 11 und der zweiten Oberfläche 32 des Lotformteils 3 eine homogene Schicht einer intermetallischen Phase IMP aus.

Auch für den Fall, dass das Lotformteil 3 nur mit Flussmittel auf die lotfähige Oberfläche 11 aufgeklebt wurde, wird bei dem Bügel-Selektivlöten die Schicht der intermetallischen Phase IMP in der Grenzfläche zwischen der lotfähigen Oberfläche 11 und der zweiten Oberfläche 32 des Lotformteils 3 gebildet.

Beim Bügel-Selektivlöten liegt die Löttemperatur Lt im Wesentlichen nur in der Umgebung des Bauelements 2, d.h. lokal stark begrenzt und nur für die Lötzeit Lz vor. Die gesamte von dem Bügel-Selektivlötverfahren benötigte Zeit, nämlich das Verfahren des Bügels 4, das Anpressen des Bügels 3, das Erreichen und Halten der Löttemperatur Lt und das Wegbewegen des Bügels 4 nimmt dabei vorteilhaft eine Lötzeit Lz von unter einer Minute ein. Unterstützt durch die Haltekraft beim Anpressen des Bügels können sich selbst in dieser kurzen Zeit sich die für die Hochtemperaturfestigkeit der Lotverbindung 7 benötigten intermetallischen Phasen IMP in der Lotverbindung 7 ausbilden.

Durch die kurze Lötzeit Lz und die punktuelle, lokal begrenzte Erwärmung wird der thermische Stress für bereits Reflow-gelötete weitere Bauelemente 61,62 erheblich reduziert, so dass ein Wiederaufschmelzen deren bestehender Lotverbindungen und/oder ein Anschmelzen der Bauelemente 61,62 beim Löten der hochtemperaturfesten Lotverbindung 7 im Wesentlichen ausgeschlossen ist.

Selbstverständlich können auch mehrere hochtemperaturfeste Lotverbindungen 7,71 mit dem erfindungsgemäßen Verfahren erzeugt werden; dies ist in Fig. 2a,b dargestellt. Hierfür wird die hohe Präzision des Bügel-Selektivlötverfahrens ausgenutzt.

Fig. 2a zeigt eine Seitenansicht einer Leiterplatte, mit mittig angeordneten weiteren Bauelementen 61,62. Bei diesen weiteren Bauelementen 61,62 handelt es sich bsp. um SMD- und/oder THT-Bauelemente, welche in einem dem Bügel-Selektivlöten vorausgehenden, gemeinsamen Reflow-Verfahren aufgelötet wurden. Insbesondere weisen die weiteren Bauelementen 61,62 bzw. deren Lotverbindung eine geringere Temperaturbeständigkeit als die Bauelemente 2,2b mit der hochtemperaurfesten Lotverbindung 7,71 auf. Für jedes dieser Bauelemente 2,2b ist jeweils ein Lotformteil 3,3b auf jeweils einer lötfähigen Oberfläche der Leiterplatte 1 befestigt. Bevorzugt ist das Befestigen der Lotformteile 3,3b in das Reflow-Verfahren zum Auflöten der weiteren Bauelemente 61,62 eingebunden.

Mittels einem im Wesentlichen automatisierten Verfahren (hier: Bewegens) des Bügels 4 in der Ebene der Leiterplatte 1 können nacheinander (Fig. 2a) die mehreren hochtemperaturfesten Lotverbindungen 7,71 erzeugt werden. Hierfür wird der Bügel 4 in der Ebene der Leiterplatte 1 verfahren. Alternativ oder zusätzlich können durch mehrere Bügel 4 im Wesentlichen gleichzeitig mehrere hochtemperaturfeste Lotverbindungen 7,71 erzeugt werden (Fig. 2b), indem die mehreren Bügel 4 im Wesentlichen gleichzeitig auf je ein Lotformteil 3,3b-Bauelement 2,2b Paar pressen. In Fig. 2a sind die Bauelemente 2,2b mit den hochtemperaturfesten Lotverbindungen 7,71 in sich gegenüberliegenden Randbereichen der Leiterplatte 1 angeordnet, wohingegen in Fig. 2b die Bauelemente 2,2b mit den hochtemperaturfesten Lotverbindungen 7,71 aneinander angrenzen.

Ein Beispiel für ein Feldgerät 8 mit einer hochtemperaturfesten Lotverbindung 7;71 ist in Fig. 3 dargestellt. In diesem die Erfindung keineswegs beschränkenden Beispiel handelt es sich bei dem Feldgerät 8 um eine induktiv angetriebenes vibronisches Messgerät, nämlich eine Schwinggabel, das als Grenzschalter zur Überwachung eines vorbestimmten Füllstands eines Mediums in einem Behälter eingesetzt wird und das für Hochtemperaturanwendungen spezifiziert ist. Selbstverständlich kann es sich auch um ein anderes Feldgerät 8 handeln, beispielsweise einen bereits erwähnten keramischen Drucksensor, welcher für einen Temperaturbereich mit Temperaturen von maximal 180°C vorgesehen ist, oder ein weiteres der eingangs genannten Feldgeräte.

Die spezielle Ausgestaltung bzw. Anordnung der hochtemperaturfesten Lotverbindungen 7,71 auf der Leiterplatte 1 hängt dabei im Wesentlichen von der Anwendung bzw. der speziellen Ausgestaltung des jeweiligen Feldgeräts 8 und dessen Elektronikeinheit 9 ab, darunter unter anderen von den verwendeten Materialen (bsp. für das Gehäuse) und deren Wärmeleitfähigkeit, von der Anordnung der Elektronikeinheit 9 in dem Feldgerät 8, und/oder von der Ausgestaltung der Elektronikeinheit 9 selbst, wobei das Layout der Elektronikeinheit 9 in der Regel durch die spezielle Funktionsweise des Feldgeräts 8 bestimmt ist.

Nur gewisse Lotverbindungen der Elektronikeinheit 9 des Feldgeräts 8 sind Umgebungstemperaturen Tum von ca. 180°C (zum Beispiel durch ein heißes Prozessmedium) im Wesentlichen unmittelbar ausgesetzt. Diese sind als hochtemperaturfeste Lotverbindungen 7,71 ausgestaltet, welche mit dem erfindungsgemäßen Verfahren selektiv erhalten werden. Der restliche Bereich der Leiterplatte 1, insbesondere die weiteren Bauelemente 61,62 und deren Lotverbindungen, sind dabei in der Fertigung vor thermischen Stress geschützt, da mithilfe des Lotformteils 3,3b und des Bügel-Selektivlötverfahrens besonders rasch und lokal begrenzt hochtemperaturfeste Lotverbindungen 7,71 erhalten werden können.

### Bezugszeichen und Symbole

- 1: Leiterplatte
- 11: lotfähige Oberfläche der Leiterplatte
- 2;2b: Bauelement
- 21: erste Oberfläche des Bauelements
- 22: zweite Oberfläche des Bauelements
- 3;3b: Lotformteil
- 31: erste Oberfläche des Lotformteils
- 32: zweite Oberfläche des Lotformteils
- 4;41;42,...: Bügel
- 5: Lotpaste
- 61,62: weitere Bauelemente
- 7,71,...: hochtemperaturfeste Lotverbindungen
- 8: Feldgerät
- 9: Elektronikeinheit
- 10: Kontaktfläche

- Lt: Löttemperatur
- Lz: Lötzeit
- VK1: erste Verbundkomponente
- VK2: zweite Verbundkomponente
- IMP: intermetallische Phasen
- Tum: Umgebungstemperaturen

## Patentansprüche

1. Verfahren zur Herstellung einer hochtemperaturfesten bleifreien Lotverbindung (7) zwischen einer Leiterplatte (1) und einem Bauelement (2;2b), bei dem
- ein bleifreies Lotformteil (3;3b) verwendet wird, das einen Verbundwerkstoff mit einer im Wesentlichen in Schichten angeordneten ersten Verbundkomponente (VK1) aufweist, wobei das Lotformteil (3;3b) als erste Verbundkomponente (VK1) eine Zinn aufweisende Lotlegierung mit einer Liquiditätstemperatur von unter 250°, und als zweite Verbundkomponente (VK2) eine metallische Matrix aufweist;
- das Lotformteil (3;3b) derart auf einer lötfähigen Oberfläche (11) der Leiterplatte (1) befestigt wird, dass sich die Schichten der ersten Verbundkomponente (VK1) im Wesentlichen parallel zur lötfähigen Oberfläche (11) erstrecken;
- das Bauelement (2;2b) auf dem auf der lötfähigen Oberfläche (11) befestigten Lotformteil (3;3b) aufgebracht wird, wobei das Bauelement (2;2b) eine dem Lotformteil (3;3b) zugewandte lötfähige erste Oberfläche (21) aufweist; und
- das Bauelement (2;2b) mit dem Lotformteil (3;3b) in einem Bügel-Selektivlötverfahren verlötet wird, das zumindest folgende Schritte umfasst:
--Pressen eines Bügels (4) auf eine dem Lotformteil (3;3b) abgewandte zweite Oberfläche (22) des Bauelements (2;2b);
--Erreichen einer vorgegebenen Löttemperatur (Lt) mittels eines den Bügel (4) durchfließenden elektrischen Stroms, wobei als die vorgegebene Löttemperatur (Lt) eine Temperatur zwischen 250°C und 400°C verwendet wird,
wobei bei der vorgegebenen Löttemperatur eine der lotfähigen Oberfläche (11) abgewandte, erste Oberfläche (31) des Lotformteils (3;3b) mit der dem Lotformteil (3;3b) zugewandten lötfähigen ersten Oberfläche (21) des Bauelements (2;2b) verlötet wird und wobei der aus den Schichten der ersten Verbundkomponente (VK1) intermetallische Phasen (IMP) gebildet werden, wobei die Lotverbindung (7;71) eine Vielzahl von im Wesentlichen schichtförmigen und im Wesentlichen parallel zur lötfähigen Oberfläche angeordneten intermetallischen Phasen (IMP) aufweist, welche intermetallischen Phasen (IMP) der Lotverbindung (7;71) in einer zu der lötfähigen Oberfläche (11) der Leiterplatte (1) senkrechten Richtung im Wesentlichen gleichmäßig verteilt angeordnet sind; und
-- Wegbewegen des Bügels (4) von dem Bauelement (2;2b).

2. Verfahren nach Anspruch 1,
wobei in dem Bügel-Selektivlötverfahren eine Lötzeit (Lz) verwendet wird, die kleiner als eine Minute, insbesondere kleiner als 30 Sekunden, ist.

3. Verfahren nach zumindest einem der vorherigen Ansprüche,
wobei die Befestigung des Lotformteils (3;3b) auf der lötfähigen Oberfläche (11) der Leiterplatte (1) zumindest folgende Schritte umfasst:
- Aufbringen, insbesondere Aufdrucken, von Lotpaste (5) auf eine vorgesehene Kontaktfläche (9) auf der lötfähigen Oberfläche (11) der Leiterplatte (1);
- Bestücken der die Lotpaste (5) aufweisenden, vorgesehenen Kontaktfläche (6) mit dem Lotformteil (3;3b).

4. Verfahren nach Anspruch 3,
wobei die Befestigung des Lotformteils (3;3b) auf der lötfähigen Oberfläche (11) der Leiterplatte (1) zumindest folgenden Schritt umfasst:
- Verlöten des Lotformteils (4) mit der Kontaktfläche (6) in einem Weichlötverfahren.

5. Verfahren nach zumindest einem der vorherigen Ansprüche 1 bis 2,
wobei die Befestigung des Lotformteils (4) auf der lötfähigen Oberfläche (11) der Leiterplatte (1) zumindest folgende Schritte umfasst:
- Kleben des Lotformteils (3;3b) auf die lötfähige Oberfläche (11), insbesondere unter Verwendung eines Flussmittels.

6. Verfahren nach zumindest einem der vorherigen Ansprüche,
wobei die Befestigung des Lotformteils (3;3b) zumindest teilweise in einen gemeinsamen Druck- und/oder Bestückungs- und/oder Reflow-Prozess einbindbar ist, bei welchem weitere Bauelemente (61,62,...), insbesondere SMD-Bauelemente, auf die Leiterplatte (1) aufgelötet werden.

7. Verfahren nach zumindest einem der vorherigen Ansprüche,
wobei das Bügel-Selektivlötverfahren zumindest folgenden Schritt umfasst:
- Verlöten einer der lötfähigen Oberfläche (11) der Leiterplatte (1) zugewandten zweiten Oberfläche des Lotformteils (32) mit der lötfähigen Oberfläche (11) der Leiterplatte (1).

8. Verfahren nach zumindest einem der vorherigen Ansprüche,
wobei ein Lotformteil (3;3b) verwendet wird, das als metallische Matrix eine Kupfermatrix aufweist.

9. Verfahren nach zumindest einem der vorherigen Ansprüche,
wobei hintereinander eine Vielzahl von hochtemperaturfesten Lotverbindungen (7,71,...) erzeugt wird, indem der Bügel (4) in der Ebene der Leiterplatte (1) und/oder die Leiterplatte (1) verfahren wird und die Schritte des Bügel-Selektivlötverfahrens jeweils nacheinander mit jeweils einem Bauelement (2,2b)- Lotformteil (3,3b) Paar durchgeführt werden.

10. Verfahren nach zumindest einem der vorherigen Ansprüche,
wobei im Wesentlichen gleichzeitig mit einer Vielzahl von Bügeln (41,42,...) eine Vielzahl von hochtemperaturfesten Lotverbindungen (7,71,...) erzeugt wird, indem die Vielzahl der Bügel (41,42,...) im Wesentlichen gleichzeitig die Schritte des Bügel-Selektivlötverfahrens mit jeweils einem Bügel (41;42) für ein Bauelement (2,2b)-Lotformteil (3,3b) Paar durchführen.

11. Anordnung aus einer Leiterplatte (1) und einem Bauelement (2,2b,...), die mittels einer hochtemperaturfesten bleifreien Lotverbindung (7;71) miteinander verbunden sind, welche hochtemperaturfeste bleifreie Lotverbindung (7;71) durch ein Bügel-Selektivlötverfahren nach zumindest einem der Ansprüche 1 bis 10 erhalten ist, wobei die Lotverbindung (7;71) eine Vielzahl von im Wesentlichen schichtförmigen und im Wesentlichen parallel zur lötfähigen Oberfläche angeordneten intermetallischen Phasen (IMP) aufweist, welche intermetallischen Phasen (IMP) der Lotverbindung (7;71) in einer zu der lötfähigen Oberfläche (11) der Leiterplatte (1) senkrechten Richtung im Wesentlichen gleichmäßig verteilt angeordnet sind, wobei die hochtemperaturfeste bleifreie Lotverbindung (7;71) bei Umgebungstemperaturen (Tum) von bis zumindest 200°C, insbesondere bis zumindest 400° C, beständig ist.

12. Anordnung nach Anspruch 11,
wobei der Anteil der intermetallischen Phasen (IMP) an der hochtemperaturfesten bleifreien Lotverbindung (7;71) zumindest 5%, insbesondere zumindest 10% beträgt.

13. Feldgerät (8) der Automatisierungstechnik zur Bestimmung und/oder Überwachung der Prozessgröße eines Mediums,
mit einer Elektronikeinheit (9), die zumindest eine Leiterplatte (1) mit darauf aufgelöteten elektrischen und/oder elektronischen Bauelementen (2;2b,61;62;...) aufweist, wobei die Elektronikeinheit die Anordnung nach zumindest einem der vorherigen Ansprüche 11 bis 12 umfasst, so dass für mindestens eines der Bauelemente (2,2b) dessen Lotverbindung mit der Leiterplatte (1) als eine hochtemperaturfeste Lotverbindung (7;71) ausgebildet ist.

## Claims

1. Method to produce a high temperature resistant, lead-free solder connection (7) between a PCB (1) and a component (2;2b), in which
- a lead-free solder preform (3;3b) is used that exhibits a composite material with a first composite component (VK1) that is essentially arranged in layers, wherein the solder preform (3;3b) as the first composite component (VK1) exhibits a solder alloy containing tin with a melting point of below 250°, as well as a metallic matrix as a second composite component (VK2);
- the solder preform (3;3b) is attached to a solderable surface (11) of the PCB (1) in such a way that the layers of the first composite component (VK1) essentially extend parallel to the solderable surface (11);
- the component (2;2b) is connected to the solder preform (3;3b), which is itself attached to the solderable surface (11), wherein the component (2;2b) exhibits a solderable first surface (21) that faces the solder preform (3;3b); and
- the component (2;2b) is soldered to the solder preform (3;3b) using a selective bar soldering process that encompasses at least the following steps:
∘ Pressing a bar (4) onto a second surface (22) of the component (2;2b) that faces away from the solder preform (3;3b);
∘ Achieving a specified soldering temperature (Lt) via an electrical current that flows through the bar (4), wherein a temperature between 250°C and 400°C is used as the specified soldering temperature (Lt), wherein a first surface (31) of the solder preform (3;3b) that faces away from the solderable surface (11) is soldered to the first surface (21) of the component (2;2b) that faces the solder preform (3;3b) at the predefined soldering temperature and wherein the intermetallic phases (IMP) are formed from the layers of the first composite component (VK1), wherein the solder connection (7;71) exhibits a plurality of essentially lamellar intermetallic phases (IMP) which are essentially arranged parallel to the solderable surface, and wherein the intermetallic phases (IMP) of the solder connection (7;71) are essentially distributed evenly and arranged in a vertical direction relative to the solderable surface (11) of PCB (1); and
∘ Moving the bar (4) away from the component (2;2b).

2. Method according to claim 1,
wherein a solder time (Lz) of less than one minute, in particular less than 30 seconds, is used in the selective bar soldering process.

3. Method according to at least one of the preceding claims,
wherein the attachment of the solder preform (3;3b) on the solderable surface (11) of the PCB (1) encompasses at least the following steps:
- Applying, in particular pressing on, solder paste (5) onto a provided contact area (9) on the solderable surface (11) of the PCB (1);
- Attaching the solder preform (3;3b) exhibiting the solder paste (5) onto the provided contact surface (6).

4. Method according to claim 3,
wherein the attachment of the solder preform (3;3b) on the solderable surface (11) of the PCB (1) encompasses at least the following step:
- Soldering of the solder preform (4) to the contact area (6) in a soft soldering process.

5. Method according to at least one of the preceding claims 1 to 2,
wherein the attachment of the solder preform (4) on the solderable surface (11) of the PCB (1) encompasses at least the following steps:
- Bonding of the solder preform (3;3b) on the solderable surface (11), in particular using a flux.

6. Method according to at least one of the preceding claims,
wherein the attachment of the solder preform (3;3b) can be integrated at least partially into a common pressure and/or placement and/or reflow process, in which further components (61,62, ...), in particular SMD components, are soldered onto the PCB (1).

7. Method according to at least one of the preceding claims,
wherein the selective bar soldering process encompasses at least the following step:
- Soldering of a second surface of the solder preform (32) that faces the solderable surface (11) of the PCB (1) to the solderable surface (11) of the PCB (1).

8. Method according to at least one of the preceding claims,
wherein a solder preform (3;3b) is used that exhibits a copper matrix as a metallic matrix.

9. Method according to at least one of the preceding claims,
wherein a plurality of high temperature resistant solder connections (7,71,...) is produced one after the other by the bar (4) being moved at the level of the PCB (1) and/or the PCB (1) being moved and the steps of the selective bar soldering process each being performed one after the other with one component (2,2b) and one solder preform (3,3b) as a pair.

10. Method according to at least one of the preceding claims,
wherein a plurality of high temperature resistant solder connections (7,71, ...) is produced essentially at the same time using a plurality of bars (41,42, ...) by the plurality of bars (41,42, ...) performing the steps of the selective bar soldering process essentially at the same time each with one bar (41;42) for a component (2,2b) and solder preform (3,3b) as a pair.

11. Arrangement of one PCB (1) and one component (2,2b, ...), which are connected to one another by means of a high temperature resistant, lead-free solder connection (7;71), wherein the high temperature resistant, lead-free solder connection (7;71) is created using a selective bar soldering process according to at least one of the claims 1 to 10,
wherein the solder connection (7;71) exhibits a plurality of essentially lamellar intermetallic phases (IMP) which are essentially arranged parallel to the solderable surface and wherein the intermetallic phases (IMP) of the solder connection (7;71) are essentially distributed evenly and arranged in a vertical direction relative to the solderable surface (11) of PCB (1),
wherein the high temperature resistant, lead-free solder connection (7;71) is capable of withstanding ambient temperatures of up to at least 200°C, in particular up to at least 400° C.

12. Arrangement according to claim 11,
wherein the proportion of the intermetallic phases (IMP) on the high temperature resistant, lead-free solder connection (7;71) is at least 5%, in particular at least 10%.

13. Field device (8) from the field of automation technology for determining and/or monitoring the process variable of a medium, featuring an electronic unit (9) that exhibits at least one PCB (1) with electrical and/or electronic components soldered onto it (2;2b,61;62;...), wherein the electronic unit encompasses the arrangement according to at least one of the preceding claims 11 to 12, such that the solder connection to the PCB (1) is produced as a high temperature resistant solder connection (7;71) for at least one of the components (2,2b).

## Revendications

1. Procédé destiné à la fabrication d'une connexion soudée sans plomb résistante aux hautes températures (7) entre une carte à circuit imprimé (1) et un composant (2, 2b), procédé pour lequel
- on utilise une pièce moulée en soudure sans plomb (3, 3b), laquelle présente un matériau composite avec un premier composant composite (VK1) disposé essentiellement en couches, la pièce moulée en soudure (3, 3b) comprenant comme premier composant composite (VK1) un alliage de soudure présentant de l'étain avec une température de liquéfaction inférieure à 250 °C, et comme deuxième composant composite (VK2) une matrice métallique ;
- la pièce moulée en soudure (3, 3b) est fixée sur une surface soudable (11) de la carte à circuit imprimé (1) de telle sorte que les couches du premier composant composite (VK1) s'étendent essentiellement parallèlement à la surface soudable (11) ;
- le composant (2, 2b) est appliqué sur la pièce moulée en soudure (3, 3b) fixée sur la surface soudable (11), le composant (2, 2b) présentant une première surface soudable (21) orientée vers la pièce moulée en soudure (3, 3b) ; et
- le composant (2, 2b) est soudé à la pièce moulée en soudure (3, 3b) dans un procédé de soudage sélectif à l'étrier, lequel procédé comprend au moins les étapes suivantes :
-- Pressage d'un étrier (4) sur une deuxième surface (22) du composant (2, 2b) opposée à la pièce moulée en soudure (3, 3b) ;
-- Atteinte d'une température de soudage (Lt) prédéfinie au moyen d'un courant électrique traversant l'étrier (4), en utilisant comme température de soudage (Lt) prédéfinie une température comprise entre 250 °C et 400 °C,
étape dans laquelle, à la température de soudage prédéfinie, une première surface (31) de la pièce moulée en soudure (3, 3b), opposée à la surface soudable (11), est reliée à la première surface soudable (21) - tournée vers la pièce moulée en soudure (3, 3b) - du composant (2, 2b), des phases intermétalliques (IMP) étant formées à partir des couches du premier composant composite (VK1), la connexion soudée (7, 71) présentant une pluralité de phases intermétalliques (IMP) pour l'essentiel en forme de couches et disposées pour l'essentiel parallèlement à la surface soudable, lesquelles phases intermétalliques (IMP) de la connexion soudée (7, 71) sont disposées de manière pour l'essentiel uniformément répartie dans une direction perpendiculaire à la surface soudable (11) de la carte à circuit imprimé (1) ; et
-- Éloignement de l'étrier (4) du composant (2, 2b).

2. Procédé selon la revendication 1,
pour lequel, dans le procédé de soudage sélectif à l'étrier, on utilise un temps de soudage (Lz) qui est inférieur à une minute, notamment inférieur à 30 secondes.

3. Procédé selon au moins l'une des revendications précédentes,
pour lequel la fixation de la pièce moulée en soudure (3, 3b) sur la surface soudable (11) de la carte à circuit imprimé (1) comprend au moins les étapes suivantes :
- Application, notamment impression, de pâte à souder (5) sur une surface de contact (9) prévue sur la surface soudable (11) de la carte à circuit imprimé (1) ;
- Équipement de la surface de contact (6) prévue, présentant la pâte à souder (5), avec la pièce moulée en soudure (3, 3b).

4. Procédé selon la revendication 3,
pour lequel la fixation de la pièce moulée en soudure (3, 3b) sur la surface soudable (11) de la carte à circuit imprimé (1) comprend au moins l'étape suivante :
- Soudage de la pièce moulée en soudure (4) à la surface de contact (6) par un procédé de soudage tendre.

5. Procédé selon au moins l'une des revendications précédentes 1 à 2,
pour lequel la fixation de la pièce moulée en soudure (4) sur la surface soudable (11) de la carte à circuit imprimé (1) comprend au moins l'étape suivante :
- Collage de la pièce moulée en soudure (3, 3b) sur la surface soudable (11), notamment en utilisant un décapant de soudage.

6. Procédé selon au moins l'une des revendications précédentes,
pour lequel la fixation de la pièce moulée en soudure (3, 3b) peut être intégrée au moins partiellement dans un processus commun d'impression et/ou d'équipement et/ou de refusion, au cours duquel d'autres composants (61 , 62, ...), notamment des composants CMS, sont soudés sur la carte à circuit imprimé (1).

7. Procédé selon au moins l'une des revendications précédentes,
pour lequel le procédé de soudage sélectif à l'étrier comprend au moins l'étape suivante :
- Soudage d'une deuxième surface de la pièce moulée en soudure (32) - tournée vers la surface soudable (11) de la carte à circuit imprimé (1) - à la surface soudable (11) de la carte à circuit imprimé (1).

8. Procédé selon au moins l'une des revendications précédentes,
pour lequel on utilise une pièce moulée en soudure (3, 3b), laquelle présente comme matrice métallique une matrice de cuivre.

9. Procédé selon au moins l'une des revendications précédentes,
pour lequel on produit successivement une pluralité de connexions soudées résistantes aux hautes températures (7, 71, ...) en déplaçant l'étrier (4) dans le plan de la carte à circuit imprimé (1) et/ou en déplaçant la carte à circuit imprimé (1), puis en exécutant les unes après les autres les étapes de procédé de soudage sélectif à l'étrier avec respectivement une paire « composant (2, 2b) - pièce moulée en soudure (3, 3b) ».

10. Procédé selon au moins l'une des revendications précédentes,
pour lequel on produit pour l'essentiel simultanément avec une pluralité d'étriers (41, 42, ...) une pluralité de connexions soudées résistantes aux hautes températures (7, 71, ...) en ce que la pluralité d'étriers (41, 42, ...) exécutent pour l'essentiel simultanément les étapes du procédé de soudage sélectif à l'étrier avec respectivement un étrier (41, 42) pour une paire « composant (2, 2b) - pièce moulée en soudure (3, 3b) ».

11. Arrangement constitué d'une carte à circuit imprimé (1) et d'un composant (2, 2b, ... ), lesquels sont reliés l'un à l'autre au moyen d'une connexion soudée sans plomb résistante aux hautes températures (7, 71), laquelle connexion soudée sans plomb résistante aux hautes températures (7, 71) est obtenue par un procédé de soudage sélectif à l'étrier selon au moins l'une des revendications 1 à 10, la connexion de soudage (7, 71) comprenant une pluralité de phases intermétalliques (IMP) pour l'essentiel en forme de couche et pour l'essentiel parallèles à la surface soudable, lesquelles phases intermétalliques (IMP) de la connexion soudée (7, 71) sont réparties pour l'essentiel de manière uniforme dans une direction perpendiculaire à la surface soudable (11) de la carte à circuit imprimé (1),
la connexion soudée sans plomb résistante aux hautes températures (7, 71) étant résistante à des températures ambiantes (Tum) allant jusqu'à au moins 200 °C, notamment jusqu'à au moins 400 °C.

12. Arrangement selon la revendication 11,
pour lequel la proportion des phases intermétalliques (IMP) dans la connexion soudée sans plomb résistante aux hautes températures (7, 71) est d'au moins 5 %, notamment d'au moins 10 %.

13. Appareil de terrain (8) de la technique d'automatisation destiné à la détermination et/ou à la surveillance de la grandeur de process d'un produit,
avec une unité électronique (9), laquelle présente au moins une carte à circuit imprimé (1) sur laquelle sont soudés des composants électriques et/ou électroniques (2, 2b ; 61,62 ; ...), l'unité électronique comprenant l'arrangement selon au moins l'une des revendications 11 à 12 précédentes, de sorte que pour au moins l'un des composants (2, 2b), sa connexion soudée avec la carte à circuit imprimé (1) est réalisée sous la forme d'une connexion soudée résistante aux hautes températures (7, 71).
